# FASCICULE DE BREVET EUROPEEN

(11) **EP 2 856 360 B1**
(45) Date de publication et mention de la délivrance du brevet: **30.06.2021**
(21) Numéro de dépôt: 13724840.7
(22) Date de dépôt: 24.05.2013
(51) Int. Cl.: G06F 30/34, G06F 30/331

(54) **PROTOTYPAGE MULTI-FPGA D'UN CIRCUIT ASIC**
MULTI-FPGA-PROTOTYPENTWICKLUNG EINER ASIC-SCHALTUNG
MULTI-FPGA PROTOTYPING OF AN ASIC CIRCUIT

(30) Priorité: 01.06.2012 FR 1201577
(43) Date de publication de la demande: 08.04.2015
(73) Titulaire: Siemens Industry Software Inc., Plano, TX 75024-6612 (US)
(72) Inventeur: MARRAKCHI, Zied, F-75013 Paris (FR); ALEXANDRE, Christophe, F-93500 Pantin (FR)
(74) Mandataire: Horn Kleimann Waitzhofer Patentanwälte PartG mbB
(86) Numéro de dépôt international: PCT/EP2013/060718
(87) Numéro de publication internationale: WO 2013/178543

(56) Documents cités:
- US-A- 5 761 484
- CHUNGHEE KIM ET AL: "A Performance-Driven Logic Emulation System: FPGA Network Design and Performance-Driven Partitioning", IEEE TRANSACTIONS ON COMPUTER AIDED DESIGN OF INTEGRATED CIRCUITS AND SYSTEMS, IEEE SERVICE CENTER, PISCATAWAY, NJ, US, vol. 15, no. 5, 1 mai 1996 (1996-05-01), XP011007284, ISSN: 0278-0070
- Russell Tessier: "Multi-FPGA Systems: Logic Emulation." In: "Reconfigurable Computing: The Theory and Practice of FPGA-Based Computation", 1 janvier 2008 (2008-01-01), Morgan Kaufmann, XP055053125, ISBN: 978-0-12-370522-8 pages 637-669, page 641 page 643 - page 648 page 654 - page 658
- JONATHAN BABB ET AL: "Logic Emulation with Virtual Wires", IEEE TRANSACTIONS ON COMPUTER AIDED DESIGN OF INTEGRATED CIRCUITS AND SYSTEMS, IEEE SERVICE CENTER, PISCATAWAY, NJ, US, vol. 16, no. 6, 1 juin 1997 (1997-06-01), XP011007437, ISSN: 0278-0070
- HELENA KRUPNOVA ET AL: "A hierarchy-driven FPGA partitioning method", 19970613; 19970609 - 19970613, 13 June 1997 (1997-06-13), pages 522-525, XP058190314, DOI: 10.1145/266021.266271 ISBN: 978-0-89791-920-3
- WEN-JONG FANG ET AL: "Multiway FPGA partitioning by fully exploiting design hierarchy", ACM TRANSACTIONS ON DESIGN AUTOMATION OF ELECTRONIC SYSTEMS, ACM, NEW YORK, NY, US, vol. 5, no. 1, 1 January 2000 (2000-01-01) , pages 34-50, XP058348581, ISSN: 1084-4309, DOI: 10.1145/329458.329463

## Description

L'invention concerne le prototypage d'un circuit ASIC au moyen d'un système de type multi-FPGA.

### ARRIERE PLAN DE L'INVENTION

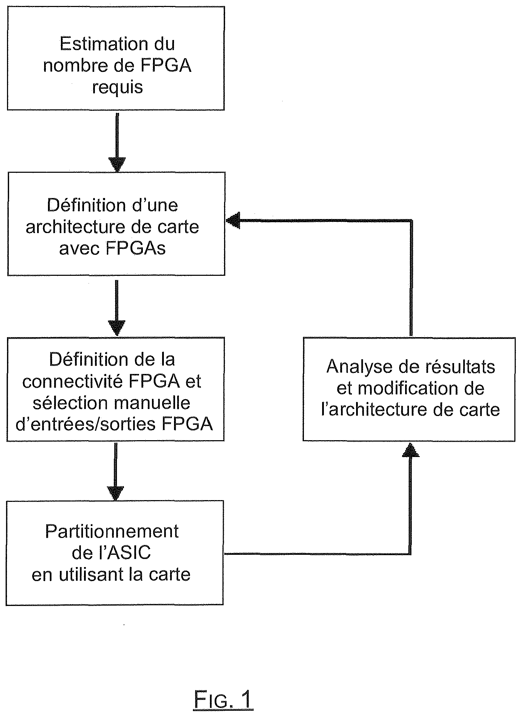

Dans les solutions connues, un tel processus nécessite d'identifier manuellement le nombre de FPGAs requis pour réaliser le prototypage du circuit ASIC envisagé. Ceci est habituellement réalisé comme suit, conformément à l'illustration schématique donnée en figure 1.

Il faut commencer avec une estimation des FPGAs qui peut être une estimation grossière, par exemple basée sur le nombre de blocs fonctionnels que l'on souhaite intégrer pour créer le circuit. Une possibilité peut consister à séparer chaque bloc fonctionnel en un FPGA ou en un jeu de plusieurs FPGAs. Alternativement, on peut utiliser un outil de synthèse pour calculer les ressources FPGA equivalents qui sont requises.

Lorsque les FPGA nécessaires ont été identifiés, il faut estimer le nombre de connexions nécessaires entre les différents FPGA. Là encore, si l'on utilise une approche dans laquelle chaque bloc fonctionnel est un FPGA, les connections entre blocs fonctionnels seront les connections entre les FPGA de la carte.

Il est alors nécessaire de créer le board Verilog netlist qui définit chaque FPGAs et les connections entre les différents FPGAs. Utilisant toute cette information, on peut débuter le processus de partitionnment de l'ASIC en plusieurs FPGAs, ce qui nécessite d'utiliser un outil de synthèse.

En pratique, il peut être nécessaire de supprimer ou d'ajouter des FPGAs et des connexions entre FPGAs pour permettre un partitionnement satisfaisant.

En pratique, un tel processus d'établissement d'un prototype FPGA de circuit ASIC peut prendre jusqu'à six mois, sans qu'il soit certain qu'une solution optimale soit atteinte.

Les articles "A Performace-Driven Logic Emulation System: FPGA Network Design and Performance-Driven Partitioning" de Kim Chunghee et al. (publié le 1er Mai 1996 dans "IEEE transactions on computer aided design of integrated circuits and systems"), "Multi-FPGA" Systems: Logic Emulation" de Russell Tessier (publié dans "Reconfigurable computing: the theory and practice of FPGA-based computation" le 1er janvier 2008), "A Hierarchy-Driven FPGA Partitionning Method" de H. Krupnova et. al. (13 juin 1997) et "Multiway FPGA partitioning by fully exploiting design hierarchy" de W.-J. Fang et. al. (dans "ACM transactions on design automation of electronic systems" le 1er janvier 2000) décrivent différentes façons de concevoir des puces FPGA dans le but d'émuler des conceptions de circuits.

### OBJET DE L'INVENTION

Le but de l'invention est de proposer une solution pour remédier à ces inconvénients.

### BREVE DESCRIPTION DES FIGURES

La figure 1 est une représentation schématique de flux de conception d'un prototype multi-FPGA d'un circuit ASIC selon les méthodes connues.
La figure 2 est une représentation schématique du contexte technique ;
La figure 3 est une représentation schématique de la solution selon l'invention ;
La figure 4 est une représentation schématique du flux général du compilateur selon l'invention ;
La figure 5 est une représentation schématique du flux itératif guidé par contrainte temporelle du compilateur selon l'invention ;
La figure 6 est une représentation schématique de la hiérarchie de conception logique utilisée dans l'analyse de conception selon l'invention ;
La figure 7 est une représentation schématique de l'analyse de conception selon l'invention ;
La figure 8 est une représentation schématique de partitionnement récursif / hiérarchique selon l'invention ;
La figure 9 est une représentation schématique de partitionnement multi-objectifs selon l'invention ;
La figure 10 est une représentation schématique de routeur de congestion négociée pondérée selon l'invention;
La figure 11 est une représentation schématique de synthèse et routage d'une interconnexion configurable conformément à l'invention.

### DESCRIPTION DETAILLEE DE L'INVENTION

L'invention est définie dans les revendications indépendantes jointes.

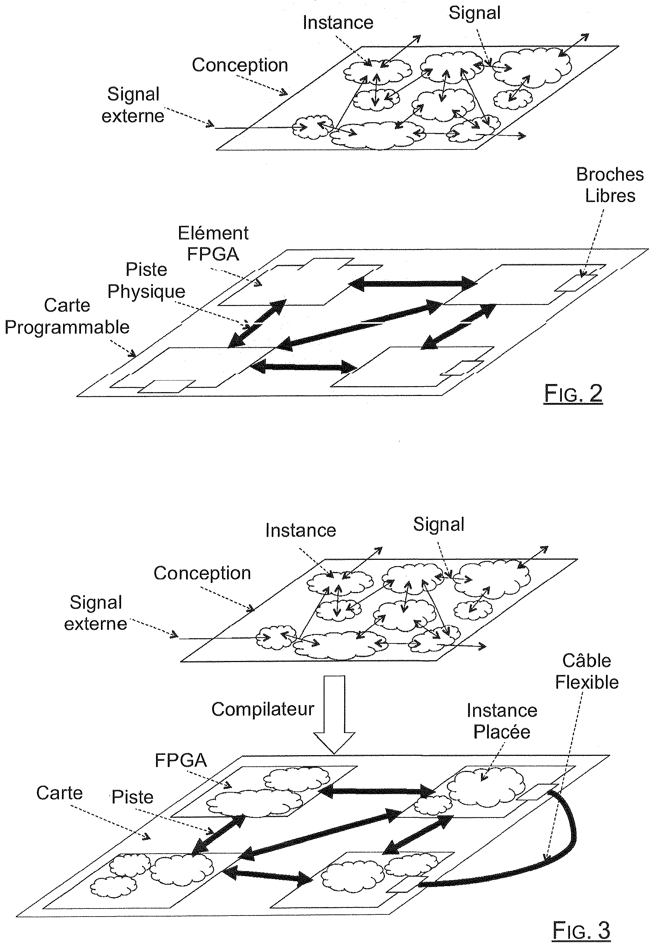

### • PRESENTATION (FIGURE 2)

### • Définitions :

Conception Logique : c'est un jeu d'instances logiques (modules). Chaque module communique avec différents autres modules par des signaux. Chaque module a une valeur de ressources logiques qui correspond à la quantité de ressources logiques qu'il contient. Les ressources de modules sont déterminées par le processus de synthèse logique. Conception logique et liste d'interconnexions de conception sont utilisées de manière interchangeable dans ce document.

Système configurable : C'est une plateforme matérielle contenant de multiples éléments hétérogènes programmables interconnectés par des pistes physiques (pistes du circuit imprimé). Chaque élément programmable a une capacité logique qui correspond à la quantité de chaque ressource logique qu'il contient. Une ressource logique est un bloc logique de base (Lut, Ram...) contenu dans l'élément.

On peut distinguer deux types d'interconnexion, à savoir d'une part les interconnexions figées qui sont des pistes physiques connectant des broches des éléments, et d'autre part les interconnexions flexibles qui sont des connecteurs physiques flexibles permettant de connecter des broches libres des éléments, par des câbles.

### • Description :

Ce système peut être considéré comme une conception logique dans laquelle les instances sont des éléments programmables et les signaux sont les pistes physiques.

Système Configurable et liste d'Interconnexions de carte sont utilisés de manière interchangeable dans la suite, et de façon analogue, élément programmable et FPGA sont utilisés de manière interchangeable dans la suite.

Identification : **Il s'agit de** mettre en correspondance une conception logique sur un système configurable. **Les contraintes** sont d'une part la limite des ressources logiques disponibles par élément programmable (contrainte de ressource logique), et d'autre part la limite des broches disponibles par élément et la limite des pistes de connexion entre paires d'éléments (contrainte de connexions logiques). **L'objectif** est d'obtenir une fréquence système maximale.

### • SOLUTION PROPOSEE (FIGURE 3)

Solution proposée : Pour les conceptions complexes étendues, la somme des ressources logiques d'instances (somme des dimensions des modules de conception) est plus grande que la somme des ressources logiques disponibles par élément (capacité des éléments).

Il est donc obligatoire de diviser (partitionner) les instances de conception entre éléments de système configurable pour surmonter la contrainte de ressources logiques.

### Contrainte de ressources logiques : Pour chaque élément, la somme des ressources d'instance < capacité de l'élément

En partitionnant, la contrainte des connexions est relaxée et transformée en un objectif de réduire les communications inter-modules quand elles sont placées dans différents éléments. Après le partitionnement, si le nombre de signaux échangés entre les parties est plus grand que le nombre de pistes physiques disponibles, il est obligatoire de grouper les signaux pour partager la même piste.

La manière dont les instances de conception sont partitionnées entre éléments programmables impacte la fréquence d'horloge maximale du système. Le compilateur selon l'invention permet de répondre à la contrainte de ressources logique et d'obtenir la fréquence d'horloge maximale du système de manière complètement automatisée.

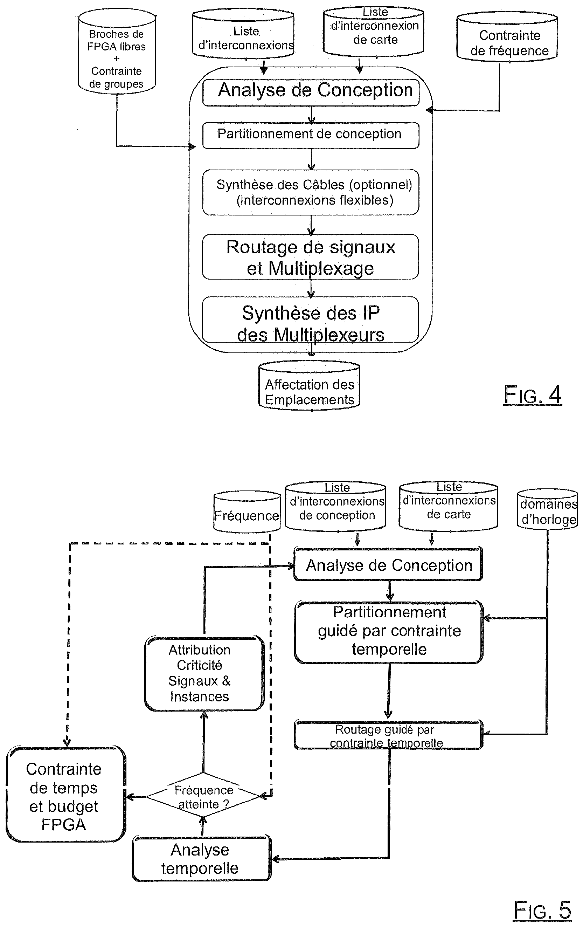

### • COMPILATEUR : FLUX GENERAL (FIGURE 4)

Le flux général du compilateur procède comme suit :
**1)** Analyse de conception : nous proposons une nouvelle méthode de partionnement FPGA, qui tire parti de la hiérarchie de circuit pour réduire la complexité du problème de partitionnement et améliorer la qualité de la partition résultante. Dans cette phase, nous sélectionnons quel module de conception doit être préservé et quel module doit être aplati pour répondre à la contrainte de ressources du FPGA et pour tirer parti de la communication locale de tels modules.
**2)** Partition de la conception : consiste à diviser les instances de conception entre éléments ;
**3)** Synthèse des câbles : définit les câbles pour connecter des broches libres de FPGA afin d'accroître les ressources de routage de la plateforme matérielle.
**4)** Routage des Signaux : Créer des groupes de signaux partageant la même piste pour répondre à la contrainte de limite de pistes.
**5)** Synthèse des IPs de Multiplexage : Génère des IPs de communication à instancier sur chaque sous-conception pour assurer le partage de pistes (Multiplexage de signaux).

### • COMPILATEUR : FLUX ITERATIF GUIDE PAR CONTRAINTE TEMPORELLE (FIGURE 5)

### • Description :

Nous proposons un flux de partitionnement guidé par contrainte temporelle pour le prototypage à base de multi-FPGA. L'objectif est de diviser une conception étendue et complexe qui ne peut pas loger dans un seul FPGA, en plusieurs sous-conceptions.

Ensuite, chaque sous-design est implémenté indépendamment dans le FPGA souhaitable correspondant. Les contraintes physiques du problème sont ainsi :
**1)** capacité logique du FPGA : ressources disponibles limitées dans chaque FPGA
**2)** Capacité d'interconnexion de la carte : pistes disponibles limitées entre FPGA

La première contrainte est stricte et il doit y être répondu par le processus de partitionnement. La seconde peut être relaxée en permettant à certains signaux inter-FPGA de partager la même piste physique (Rapport de Multiplexage). Quoi qu'il en soit, relaxer cette contrainte a un impact sur la performance du système. En fait, la fréquence du système dépend de :
- Rapport de Multiplexage : Ce paramètre définit combien de signaux sont envoyés successivement dans la période d'horloge du système sur une même piste physique.
- Nombre de signaux multiplexés dans un chemin combinatoire : Ce paramètre correspond au nombre de HOP's combinatoires multiplexés par chemin critique.

### Le flux d'implémentation de la conception se compose des étapes suivantes :

**1)** Analyse de conception : nous proposons une nouvelle méthode de partionnement FPGA, qui tire parti de la hiérarchie de circuit pour réduire la complexité du problème de partitionnement et améliorer la qualité de la partition résultante. Dans cette phase, nous sélectionnons quel module de conception doit être préservé et quel module doit être aplati pour répondre à la contrainte de ressources du FPGA et pour tirer parti de la communication locale de tels modules.
**2)** Partitionnement guidé par contrainte temporelle : Dans cette étape nous divisions la conception entre FPGA. La contrainte est de respecter les ressources disponibles par FPGA. L'objectif est de réduire conjointement le ratio de multiplexage et le HOPs combinatoire.
**3)** Routage guidé par contrainte temporelle : Cette phase consiste à spécifier les jeux de fils (groupes de signaux devant partager le même fil) et le chemin pour router ces signaux. Le routeur peut choisir de passer à travers certains FPGA (HOPs de routage) pour atteindre la destination.
**4)** Une fois que tous les signaux sont routés nous enclenchons une analyse temporelle pour estimer la fréquence du système.

Ce flux est itératif. Une itération consiste à exécuter les quatre étapes. Après l'analyse temporelle, si la fréquence requise est atteinte, nous générons la liste d'interconnexions de chaque sous-conception de FPGA, et les contraintes temporelles intra-FPGA (budget temps). Si la fréquence n'est pas atteinte, les modules et connexions critiques sont identifiés et étiquetés. La conception est analysée (étape 1) vis-à-vis de ces caractéristiques pour améliorer la qualité du résultat.

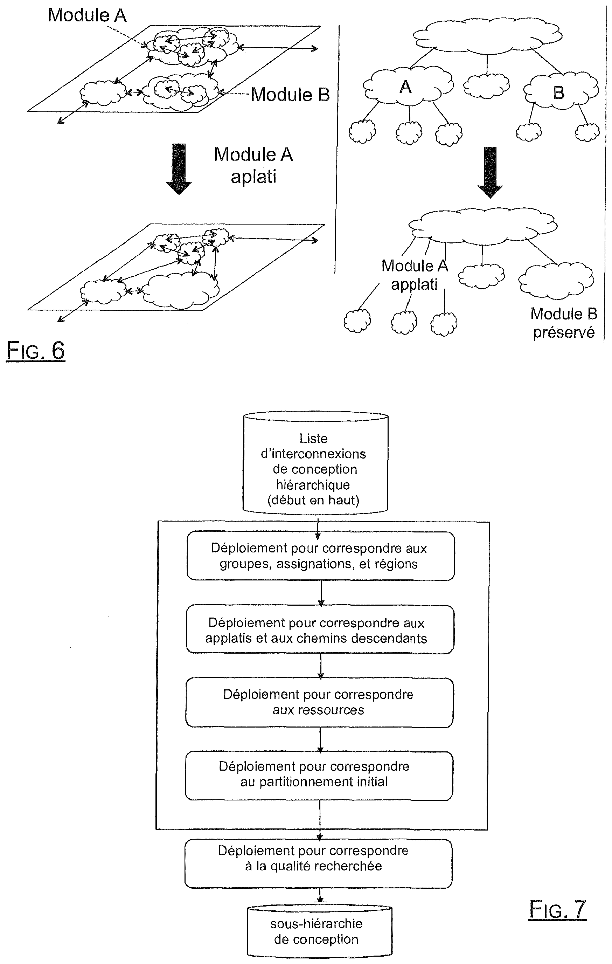

### • ANALYSE DE CONCEPTION : HIERARCHIE DE LA CONCEPTION LOGIQUE (FIGURE 6)

### • Définitions :

Module Hiérarchique (instance) : c'est un module qui instancie (contient) d'autres modules (enfants)
Module Feuille : est un module sans module enfant
Conception Hiérarchique : est une conception qui contient des modules hiérarchiques
Signal Interne : est un signal connectant seulement des enfants du même module
Signal externe : est un signal qui connecte deux enfants appartenant à deux modules différents
Aplatissement de module : le module disparaît mais nous conservons ses enfants (exemple du module A)
Préservation de module : quand nous préservons un module nous gardons son périmètre et tous ses enfants ne sont pas considérés dans la phase de partition (ils ne peuvent pas être séparés) . Exemple : le module B est préservé.

### • Description :

Dans la plupart des cas, les concepteurs décrivent leur conception (circuit logique) d'une manière hiérarchique. Cela facilite cette tâche (diviser et conquérir) et permet de la partager entre différents ingénieurs. Ces modules présentent une connectivité locale car les modules enfants doivent communiquer ensemble. La qualité de la communication locale varie selon la fonctionnalité et comment les concepteurs définissent leurs systèmes. La qualité de la communication locale d'un module : signaux internes contre signaux externes. Selon la qualité des modules on peut décider de les aplatir ou de les garder. Si le module est gardé, ses enfants ne seront pas vus lorsque nous ferons le partitionnement (ils ne peuvent pas être séparés). Nous montrons deux différentes manières de présenter une conception hiérarchique et comment nous pouvons aplatir un module hiérarchique.

### • ANALYSE DE CONCEPTION (FIGURE 7)

L'objet de l'analyse de conception est de créer une nouvelle hiérarchie de conception adaptée au processus de partition. Cette nouvelle hiérarchie est créée à partir de la hiérarchie initiale de conception en déployant les modules hiérarchiques. Les modules à déployer ou à préserver sont choisis vis-à-vis premièrement des contraintes et deuxièmement de la phase d'optimisation.

Il y a deux types de contraintes : utilisateur et implicite. Les contraintes implicites sont relatives aux caractéristiques intrinsèques au problème : quantité de ressources de conception contre quantité de ressources cible, contraintes initiales de partition. Les contraintes d'utilisateur sont déduites des commandes utilisateurs telles que les commandes d'assignation, les commandes indivisibles ou les commandes groupées.

Une fois que la hiérarchie initiale de conception a été déployée compte tenu des contraintes, une phase d'optimisation est lancée. Durant cette phase, les modules hiérarchiques de mauvaise qualité sont déployés. Le critère de qualité peut être le Nombre de Rent's du module ou sa caractéristique combinatoire/séquentielle.

Durant la première phase (déploiement de contrainte), les modules hiérarchiques de bonne qualité peuvent être déployés. Pour conserver une trace de cette perte de hiérarchie, les modules de la nouvelle hiérarchie peuvent être étiquetés avec leur parent commun perdu.

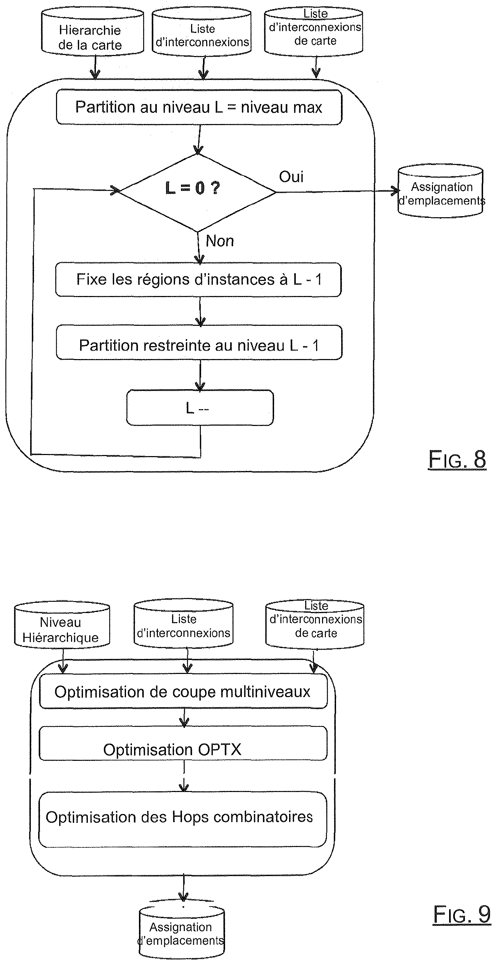

### • PARTITIONNEMENT RECURSIF/HIERARCHIQUE (FIGURE 8)

### • Description :

Le partitionnement a la capacité à s'adapter à la hiérarchie de la carte. Dans certains cas, les grandes cartes peuvent avoir un niveau de hiérarchie et être organisées en groupes de FPGA. Chaque groupe a des pistes internes (connectant des FPGAs appartenant au même groupe) et des pistes externes (connectant des FPGAs appartenant à des groupes différents). Dans ce cas, le partitionnement est fait en deux temps :
**1)** La conception est partitionnée en régions : Chaque région a des ressources limitées à la somme des ressources des FPGAs qu'elle contient. Les régions ont aussi des routages de pistes externes limités. L'objectif est de réduire les communications inter-régions (coupures de signaux). Après cette phase, les blocs de conception sont étiquetés avec les régions auxquelles ils appartiennent.
**2)** Les instances de conception appartenant à chaque région sont partitionnées entre FPGA locaux. Les instances ne sont pas autorisées à se déplacer vers un FPGA appartenant à une région différente (partitionnement restreint).

Cette technique est utilisée pour les cartes hiérarchiques multi-niveaux. Dans ce cas les régions contiennent des sous-régions et les instances de conception sont partitionnées de manière récursive N fois. N est égal au nombre de niveaux hiérarchiques.

### • PARTITIONNEMENT MULTI-OBJECTIFS (FIGURE 9)

### • Définitions :

Raffinement : C'est un processus permettant de changer l'état d'un système pour optimiser une fonction objectif (coût). Un système a un état défini par la position de ses objets. Une conception peut être un système dont les objets sont ses instances. Les positions d'instances correspondent aux FPGA dans lesquels les instances sont placées. Une fonction de coût est calculée sur la base de l'état du système (positions d'instances). Un état du système peut être perturbé en changeant la position d'un objet (l'instance est déplacée d'un FPGA à un autre). Cette perturbation est caractérisée par son gain (impact sur la valeur de la fonction coût). En processus d'optimisation, le raffinement consiste à trouver l'état de système permettant d'obtenir le minimum de la fonction coût. Le raffinement consiste à itérer des perturbations du système pour atteindre l'objectif. On peut définir principalement deux stratégies de raffinement (heuristiques) :
- raffinement de type "greedy" : dans cette stratégie seuls des déplacements à gain positif (bon impact sur la fonction coût) sont acceptés.
- raffinement de type "hill-climbing": dans cette stratégie le déplacement de meilleur gain est accepté qu'il soit positif (bon impact) ou négatif (mauvais impact).

### • Description :

Comme vu précédemment, la fréquence du système dépend principalement : du Rapport de Multiplexage qui définit combien de signaux sont envoyés successivement dans une même période d'horloge ; et du nombre de signaux multiplexés dans un chemin combinatoire, ce qui correspond au nombre de HOPs combinatoires multiplexés par chemin critique.

Ces objectifs sont compétitifs et présentent un compromis car, dans la plupart des cas, réduire la coupe peut augmenter les HOPS combinatoires entre FPGA. Dans notre solution, les deux objectifs sont réduits successivement en fonction de leur priorité et de leur complexité.
**1)** Objectif de Coupe : Un signal est coupé quand il va dans ou hors d'un pad FPGA d'entrée/sortie. Cela signifie qu'il a au moins deux terminaux appartenant à deux parties différentes (FPGA ou régions).
   Cet objectif est facile à atteindre car il peut être calculé de façon incrémentale et a été très largement pris en compte dans l'Etat de la technique. Cet objectif consiste à réduire le nombre de signaux coupés d'une façon globale. Certains signaux peuvent avoir une plus haute criticité et, en conséquence avoir un plus fort impact sur la fonction de coût.
**2)** Objectif OPTX : cet objectif est une sorte de coupe pondérée. Le poids corresponds au nombre de pistes physiques disponibles entre chaque paire de FPGA. Donc cet objectif est calculé localement (vis-à-vis de chaque paire de FPGA). Le coût correspondant à cet objectif ne peut être calculé de façon incrémentale. Pour économiser du temps et réduire la complexité, nous utilisons un algorithme de type "greedy" pour l'optimiser.
**3)** C-HOP Objective : cet objectif est complexe à calculer de façon incrémentale car l'effet d'un déplacement perturbe une large part du système. Pour alléger cette complexité nous proposons d'attaquer ce problème en utilisant notre algorithme de type "greedy". Dans chaque itération de raffinement, nous exécutons ce qui suit :
   a) Analyse temporelle
   b) Etiquetage de chaque nœud critique
   c) Création de cônes combinatoires de profondeur 1 et contenant seulement des nœuds critiques
   d) Calcul du nombre critique de HOPs
   e) Réalisation des déplacements et mise à jour des gains.

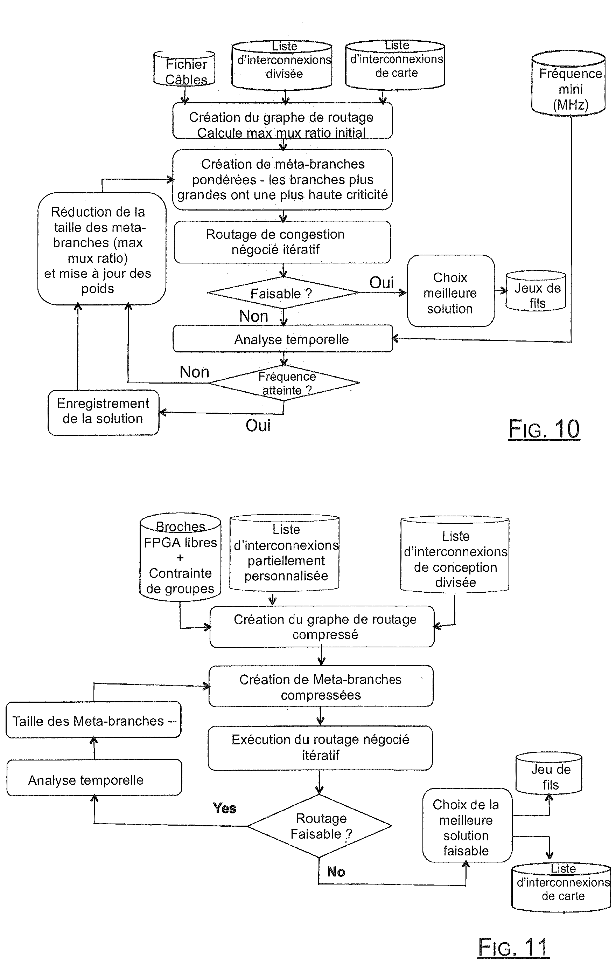

### • ROUTEUR DE CONGESTION NEGOCIEE PONDEREE (FIGURE 10)

### • Définitions :

**1)** Routage : affecter les pistes physiques aux signaux communiquant entre FPGAs
**2)** Conflit : Quand 2 signaux différents utilisent la même piste, on obtient un conflit
**3)** Routage faisable : tous les signaux sont routés sans conflit
**4)** Routage à évitement d'obstacle : les signaux sont routés successivement. Les ressources utilisées par un signal routé sont réservées et deviennent indisponibles. C'est une technique rapide mais l'ordre dans lequel on route les signaux a un impact important sur la faisabilité de la solution.
**5)** Routage de base négocié : on attribue à chaque ressource un coût. L'objectif est de router les signaux avec le chemin le plus court (somme des coûts des chemins de ressources). Le coût d'une ressource dépend du nombre de signaux qui l'utilisent. Dans chaque itération des signaux sont routés en prenant en compte le coût de ressources et en négociant leur utilisation : le routeur sélectionne la ressource ayant le plus bas coût pour router un signal.
   Dans l'Etat de la technique, la technique d'évitement d'obstacle est utilisée pour router les cartes multi-FPGA. C'est simple et rapide mais inefficace. Le routage basé sur la négociation est plus complexe (présentation des ressources en graphe et gestion des coûts de ressources) mais plus efficace.
**6)** Branche : Après partition, les signaux connectant N FPGA sont divisés en N branches point à point.
**7)** Meta-Branche : c'est un groupe de branches ayant le même élément source et le même élément de destination.

### • Description :

Malgré l'effort d'optimisation de partitionnement, dans la plupart des cas, le nombre de signaux inter-FPGA est plus grand que le nombre de pistes physiques sur la carte (limitation technologique). Le partage de pistes est la solution évidente pour résoudre un tel problème. Un signal est dit multiplexé s'il partage avec d'autres branches la même piste physique. Le rapport de multiplexage est le nombre de branches partageant la même piste physique. Les branches peuvent avoir différents ratios de multiplexage. Le choix des branches à multiplexer et le ratio de multiplexage ont un impact sur la fréquence du système. Les bas ratios de multiplexage donnent lieu à une meilleure fréquence. Le ratio de multiplexage peut être réduit en allant à travers d'autres FPGAs pour atteindre la destination finale. Dans notre technique de routage nous proposons deux aspects innovants :
**1)** Analyse de la criticité des signaux : les branches critiques (branches appartenant à des chemins ayant beaucoup de HOPs) doivent être multiplexées avec les ratios les plus bas.
**2)** Routage de branches à base de graphes : notre but est de router chaque branche avec le plus bas ratio de multiplexage. Pour ceci nous devons faire une exploration profonde des chemins disponibles. Donc, les ressources de routage de la carte sont représentées par un graphe dans lequel les nœuds sont des broches de FPGA et les bords sont des pistes physiques.

Comme illustré à la figure 10, nous proposons un flux itératif qui explore différents ratios de multiplexage de manière décroissante. Pour chaque ratio de multiplexage nous créons des méta-branches. Le ratio de multiplexage maximal représente un périmètre supérieur de la taille des méta-branches. La taille d'une méta-branche et sa criticité dépend de la criticité des branches qu'elle contient Chaque méta branche est routée sur le graphe présentant les pistes de routage physique. Nous utilisons un algorithme basé sur de la négociation itérative qui permet aux méta-branches de négocier l'utilisation des ressources disponibles. Une fois que chaque méta-branche est routée sans conflit, nous exécutons une analyse temporelle pour estimer la fréquence système. Si la fréquence estimée est supérieure à la fréquence contrainte par l'utilisateur, la solution est sauvée, sinon elle est rejetée. Le flux s'arrête quand nous atteignons un ratio de multiplexage maximal qui ne permet pas d'obtenir une solution faisable.

### • SYNTHESE ET ROUTAGE D'UNE INTERCONNEXION CONFIGURABLE (FIGURE 11)

Certains systèmes configurables ont des interconnexions flexibles et peuvent être personnalisés pour mieux correspondre aux caractéristiques du design implémenté. Donc quand la carte est fabriquée, certaines broches d'éléments sont laissées libres (non connectées par des pistes physiques aux broches d'autres éléments mais connectées à des connecteurs spécifiques). L'invention permet spécifier comment connecter les broches de connexion et ajouter des câbles entre elles. Ensuite, dans la phase de routage, ces câbles sont considérés comme étant des pistes physiques.

Les contraintes du problème des câbles sont :
- Un groupe de broches d'un élément sont connectées au même connecteur. Ce connecteur peut être connecté seulement à un autre élément par câble.
- On suppose que tous les connecteurs ont la même taille (nombre de broches d'éléments par groupe).

Le problème d'assignation des câbles peut être résolu comme ou problème de routage si l'on peut modéliser les broches libres de connexion dans le graphe de routage. Pour répondre à la contrainte selon laquelle chaque connecteur peut être connecté à seulement un connecteur, on représente un connecteur (groupe de broches) avec seulement un nœud. Le fait que les connecteurs sont flexibles est modélisé par l'ajout de bords possibilité de connecter) entre tous les nœuds (représentant des connecteurs). Les pistes restant gelées sont groupées en super-pistes. Chaque super-piste présente un groupe de pistes ayant le même élément source et destination. La taille d'une super-piste est égale à la taille du connecteur. De la même manière, chaque connecteur est représenté par un nœud. En conséquence, on obtient un graphe compressé. Nous proposons de transformer la conception dans une liste d'interconnexion compressée. On crée des super-branches qui sont des groupes de méta-branches. La taille d'une super branche est égale à la taille de connecteur. De cette manière, on peut exécuter le routage basé sur la négociation pour router la conception compressée sur le graphe compressé. La contrainte de conflit : un nœud peut être utilisé par seulement une super branche, garantit qu'un connecteur sera connecté à seulement un connecteur. Finalement le résultat du routage définit comment les branches sont groupées (multiplexées), leur chemin et connexions de connecteurs (câbles).

## Revendications

1. Procédé de conception mis en œuvre par ordinateur d'un prototype comportant plusieurs puces programmables, telles que des puces de type FPGA, interconnectées par des pistes physiques d'une carte, pour modéliser un circuit ASIC, ce circuit ASIC étant destiné à mettre en œuvre une conception logique comportant une hiérarchie de modules logiques communiquant entre eux, ce procédé comportant les étapes de :
- partitionner la hiérarchie de modules logiques en régions comportant chacune une ou plusieurs puces programmables en minimisant :
- d'une part les communications inter-régions d'une façon corrélée aux connexions physiques disponible entre chaque paire de puces programmables ;
- et d'autre part le nombre de traversée(s) de puces programmables d'un chemin combinatoire critique ; et
- établir un routage des signaux entre puces programmables en utilisant les ressources physiques disponibles, dans lequel l'établissement du routage comprend le routage des pistes physiques de la carte et des câbles reliés à des puces programmables,
dans lequel on applique de manière itérative et automatisée des modifications au partitionnement avant d'établir un nouveau routage et d'estimer la fréquence de fonctionnement du prototype formé par les puces programmables desdites régions par une analyse temporelle, jusqu'à atteindre une fréquence cible,
le procédé comportant en outre, préalablement à l'étape de partitionnement, une étape de création d'une nouvelle hiérarchie de modules logiques à partir de la hiérarchie des modules logiques de la conception logique, en aplatissant les modules ne pouvant pas être préservés, selon des contraintes de conception, tout en mettant en œuvre la conception logique, et dans laquelle l'étape de partitionnement est appliquée à cette nouvelle hiérarchie.

2. Procédé selon la revendication 1, dans lequel le partitionnement est récursif pour s'adapter à la hiérarchie de la plateforme programmable, en :
- partitionnant la hiérarchie en régions ayant chacune des ressources limitées à la somme des ressources des puces programmables qu'elle contient ;
- partitionnant les instances de conception appartenant à chaque région entre puces programmables locales sans autoriser les instances d'une puce programmable à se déplacer vers une puce programmable d'une région différente.

3. Procédé selon la revendication 1 ou 2, dans lequel l'étape d'établissement d'un routage des signaux entre les puces programmables en utilisant les ressources physiques disponibles est assurée en représentant les ressources de la carte par un graphe dans lequel les nœuds sont des broches de puces programmables et les bords sont des pistes physiques.

4. Procédé selon la revendication 1, comprenant une étape de configuration du prototype avec une liste des modules logiques et du routage des signaux.

5. Procédé selon la revendication 1, comprenant une étape d'analyse de la criticité des signaux et une étape de multiplexage des signaux, les signaux les plus critiques étant multiplexés avec les ratios de multiplexage les plus bas.

6. Système de prototypage pour mettre en œuvre une conception comprenant une hiérarchie de modules, comprenant :
une carte comprenant des pistes physiques ; et
une pluralité de puces programmables interconnectées par les pistes conductrices, les puces programmables étant configurées par un procédé comprenant :
le partitionnement de la hiérarchie de modules en régions comprenant chacune au moins une puce programmable, en minimisant les communications inter-région de manière corrélée avec les connections physiques disponibles entre chaque paire de puces programmables, et le nombre de traversée(s) de puces programmables d'un chemin combinatoire critique ; et
l'établissement d'un routage des signaux entre desdites puces programmables en utilisant les ressources physiques disponibles, dans lequel l'établissement du routage comprend le routage des pistes physiques de la carte et des câbles entre des puces programmables,
dans lequel on applique de manière itérative et automatisée des modifications au partitionnement avant d'établir un nouveau routage et d'estimer la fréquence de fonctionnement du prototype formé par les puces programmables desdites régions par une analyse temporelle, jusqu'à atteindre une fréquence cible,
le système comportant en outre, préalablement au partitionnement, une création d'une nouvelle hiérarchie de modules logiques à partir de la hiérarchie des modules logiques de la conception logique, en aplatissant les modules ne pouvant pas être préservés, selon des contraintes de conception, tout en mettant en œuvre la conception logique, et dans laquelle le partitionnement est appliqué à cette nouvelle hiérarchie.

7. Système selon la revendication 6, dans lequel l'établissement du routage des signaux comprend un multiplexage des signaux sur les pistes physiques de la carte.

8. Système selon la revendication 7, dans lequel un rapport de multiplexage est réduit en passant à travers d'autres puces programmables pour atteindre une destination finale.

9. Programme d'ordinateur du type compilateur mettant en œuvre une conception comprenant une hiérarchie de modules sur un système de prototypage comprenant une carte comprenant des pistes physiques et une pluralité de puces programmables interconnectées par les pistes conductrices, le programme étant agencé pour :
partitionner la hiérarchie de modules en régions comprenant chacune au moins une puce programmable, en minimisant les communications inter-région de manière corrélée avec les connections physiques disponibles entre chaque paire de puces programmables, et le nombre de traversée(s) de puces programmables d'un chemin combinatoire critique ; et
établir un routage des signaux entre desdites puces programmables en utilisant les ressources physiques disponibles, dans lequel l'établissement du routage comprend le routage des pistes physiques de la carte et des câbles entre des puces programmables,
dans lequel on applique de manière itérative et automatisée des modifications au partitionnement avant d'établir un nouveau routage et d'estimer la fréquence de fonctionnement du prototype formé par les puces programmables desdites régions par une analyse temporelle, jusqu'à atteindre une fréquence cible,
le programme étant en outre agencé pour, préalablement au partitionnement, créer une nouvelle hiérarchie de modules logiques à partir de la hiérarchie des modules logiques de la conception logique, en aplatissant les modules ne pouvant pas être préservés, selon des contraintes de conception, tout en mettant en œuvre la conception logique, et dans laquelle le partitionnement est appliqué à cette nouvelle hiérarchie.

10. Programme d'ordinateur selon la revendication 9, dans lequel l'établissement du routage des signaux comprend un multiplexage des signaux sur les pistes physiques de la carte.

11. Programme d'ordinateur selon la revendication 9, dans lequel un rapport de multiplexage est réduit en passant à travers d'autres puces programmables pour atteindre une destination finale.

## Patentansprüche

1. Computerimplementiertes Verfahren zur Entwicklung eines Prototypen, der mehrere programmierbare Chips aufweist, wie beispielsweise FPGA-Chips, die durch physische Bahnen einer Karte miteinander verbunden sind, um eine ASIC-Schaltung zu modellieren, wobei diese ASIC-Schaltung dazu bestimmt ist, eine Logikentwicklung umzusetzen, die eine Hierarchie von Logikmodulen aufweist, die miteinander kommunizieren, wobei dieses Verfahren die folgenden Schritte aufweist:
- Partitionieren der Hierarchie von Logikmodulen in Bereiche, die jeweils einen oder mehrere programmierbare Chips aufweisen, durch Minimierung:
- einerseits der Kommunikationen zwischen Bereichen auf eine Weise, die mit den physischen Verbindungen korreliert, die zwischen jedem Paar von programmierbaren Chips verfügbar ist;
- und andererseits der Anzahl von Durchquerungen von programmierbaren Chips von einem kritischen kombinatorischen Pfad; und
- Herstellen eines Routings der Signale zwischen programmierbaren Chips unter Nutzung der verfügbaren physischen Ressourcen, wobei das Herstellen des Routings das Routing der physischen Bahnen der Karte und der Kabel, die mit programmierbaren Chips verbunden sind, aufweist,
wobei iterativ und automatisiert Modifikationen auf die Partitionierung angewandt werden, bevor ein neues Routing hergestellt wird und die Betriebsfrequenz des Prototyps, der von den programmierbaren Chips der Bereiche durch eine Zeitanalyse geschätzt wird, bis eine Zielfrequenz erreicht wird,
das Verfahren ferner aufweisend, vor dem Schritt des Partitionierens, einen Schritt des Erzeugens einer neuen Hierarchie von Logikmodulen ausgehend von der Hierarchie der Logikmodule der Logikentwicklung durch Einebnung der Module, die nicht bewahrt werden können, gemäß Entwicklungszwängen, wobei die Logikentwicklung umgesetzt wird, und wobei der Schritt des Partitionierens auf diese neue Hierarchie angewandt wird.

2. Verfahren nach Anspruch 1, wobei das Partitionieren rekursiv ist, um sich an die Hierarchie der programmierbaren Plattform anzupassen, durch:
- Partitionierung der Hierarchie in Bereiche, die jeweils Ressourcen aufweisen, die auf die Summe der Ressourcen der programmierbaren Chips begrenzt ist, die sie enthält;
- Partitionierung der Entwicklungsinstanzen, die zu jedem Bereich gehören, zwischen lokalen programmierbaren Chips, ohne es den Instanzen eines programmierbaren Chips zu erlauben, sich zu einem programmierbaren Chip eines unterschiedlichen Bereichs zu bewegen.

3. Verfahren nach Anspruch 1 oder 2, wobei der Schritt des Herstellens eines Routings der Signale zwischen den programmierbaren Chips unter Nutzung der verfügbaren physischen Ressourcen durch Darstellung der Ressourcen der Karte durch einen Graphen sichergestellt wird, in welchem die Knoten Kontaktstifte programmierbarer Chips und die Ränder physische Bahnen sind.

4. Verfahren nach Anspruch 1, umfassend einen Schritt des Ausgestaltens des Prototypen mit einer Liste der Logikmodule und des Routings der Signale.

5. Verfahren nach Anspruch 1, umfassend einen Schritt des Analysierens der Kritizität der Signale und einen Schritt des Multiplexens der Signale, wobei die kritischsten Signale mit den niedrigsten Multiplexverhältnissen gemultiplext werden.

6. Prototyping-System zur Umsetzung einer Entwicklung, die eine Hierarchie von Modulen umfasst, umfassend:
eine Karte, die physische Bahnen umfasst; und
eine Mehrzahl von programmierbaren Chips, die durch die Leiterbahnen miteinander verbunden sind, wobei die programmierbaren Chips durch ein Verfahren ausgestaltet sind, das Folgendes umfasst:
das Partitionieren der Hierarchie von Modulen in Bereiche, die jeweils mindestens einen programmierbaren Chip umfassen, durch Minimierung der Kommunikationen zwischen Bereichen auf eine Weise, die mit den physischen Verbindungen korreliert, die zwischen jedem Paar von programmierbaren Chips verfügbar sind, und der Anzahl von Durchquerungen von programmierbaren Chips von einem kritischen kombinatorischen Pfad; und
das Herstellen eines Routings der Signale zwischen programmierbaren Chips unter Nutzung der verfügbaren physischen Ressourcen, wobei das Herstellen des Routings das Routing der physischen Bahnen der Karte und der Kabel zwischen programmierbaren Chips umfasst,
wobei iterativ und automatisiert Modifikationen auf die Partitionierung angewandt werden, bevor ein neues Routing hergestellt wird und die Betriebsfrequenz des Prototyps, der von den programmierbaren Chips der Bereiche durch eine Zeitanalyse geschätzt wird, bis eine Zielfrequenz erreicht wird,
das System ferner aufweisend, vor dem Partitionieren, ein Erzeugen einer neuen Hierarchie von Logikmodulen ausgehend von der Hierarchie der Logikmodule der Logikentwicklung durch Einebnung der Module, die nicht bewahrt werden können, gemäß Entwicklungszwängen, wobei die Logikentwicklung umgesetzt wird, und wobei das Partitionieren auf diese neue Hierarchie angewandt wird.

7. System nach Anspruch 6, wobei das Herstellen des Routings der Signale ein Multiplexen der Signale auf den physischen Bahnen der Karte umfasst.

8. System nach Anspruch 7, wobei ein Multiplexverhältnis verringert wird, indem andere programmierbare Chips durchlaufen werden, um ein Endziel zu erreichen.

9. Computerprogramm vom Typ Compiler, der eine Entwicklung umsetzt, die eine Hierarchie von Modulen auf einem Prototyping-System umsetzt, das eine Karte, die physische Bahnen umfasst, und eine Mehrzahl von programmierbaren Chips, die durch die Leiterbahnen miteinander verbunden sind, umfasst, wobei das System angeordnet ist:
die Hierarchie von Modulen in Bereiche zu partitionieren, die jeweils mindestens einen programmierbaren Chip umfassen, durch Minimierung der Kommunikationen zwischen Bereichen auf eine Weise, die mit den physischen Verbindungen korreliert, die zwischen jedem Paar von programmierbaren Chips verfügbar sind, und der Anzahl von Durchquerungen von programmierbaren Chips von einem kritischen kombinatorischen Pfad; und
ein Routing der Signale zwischen programmierbaren Chips unter Nutzung der verfügbaren physischen Ressourcen herzustellen, wobei das Herstellen des Routings das Routing der physischen Bahnen der Karte und der Kabel zwischen programmierbaren Chips aufweist,
wobei iterativ und automatisiert Modifikationen auf die Partitionierung angewandt werden, bevor ein neues Routing hergestellt wird und die Betriebsfrequenz des Prototyps, der von den programmierbaren Chips der Bereiche durch eine Zeitanalyse geschätzt wird, bis eine Zielfrequenz erreicht wird,
wobei das Programm ferner angeordnet ist, vor dem Partitionieren eine neue Hierarchie von Logikmodulen zu erzeugen, ausgehend von der Hierarchie der Logikmodule der Logikentwicklung durch Einebnung der Module, die nicht bewahrt werden können, gemäß Entwicklungszwängen, wobei die Logikentwicklung umgesetzt wird, und wobei das Partitionieren auf diese neue Hierarchie angewandt wird.

10. Computerprogramm nach Anspruch 9, wobei das Herstellen des Routings der Signale ein Multiplexen der Signale auf den physischen Bahnen der Karte umfasst.

11. Computerprogramm nach Anspruch 9, wobei ein Multiplexverhältnis verringert wird, indem andere programmierbare Chips durchlaufen werden, um ein Endziel zu erreichen.

## Claims

1. Computer-implemented method for designing a prototype comprising a plurality of programmable chips, such as chips of FPGA type, interconnected by physical tracks of a board, in order to model an ASIC circuit, this ASIC circuit being intended to implement a logic design comprising a hierarchy of logic modules communicating with one another, this method comprising the steps of:
- partitioning the hierarchy of logic modules into regions each comprising one or more programmable chips by minimizing:
- on the one hand, the inter-region communications in a manner correlated with the available physical connections between each pair of programmable chips;
- and, on the other hand, the number of traversal(s) of programmable chips of a critical combinatorial path; and
- establishing a routing of the signals between programmable chips by using the available physical resources, wherein establishing the routing comprises routing the physical tracks of the board and the cables connected to programmable chips,
wherein modifications are applied in an iterative and automated manner to the partitioning before establishing a new routing and before estimating the operating frequency of the prototype formed by the programmable chips of said regions by means of a temporal analysis, until a target frequency is reached, the method furthermore comprising, prior to the partitioning step, a step of creating a new hierarchy of logic modules on the basis of the hierarchy of the logic modules of the logic design, by flattening the modules that cannot be preserved, according to design constraints, while implementing the logic design, and wherein the partitioning step is applied to this new hierarchy.

2. Method according to Claim 1, wherein the partitioning is recursive so as to adapt to the hierarchy of the programmable platform, by:
- partitioning the hierarchy into regions each having resources limited to the sum of the resources of the programmable chips that it contains;
- partitioning the design instances belonging to each region between local programmable chips without authorizing the instances of a programmable chip to move to a programmable chip of a different region.

3. Method according to Claim 1 or 2, wherein the step of establishing a routing of the signals between the programmable chips by using the available physical resources is carried out by representing the resources of the board by means of a graph wherein the nodes are pins of programmable chips and the edges are physical tracks.

4. Method according to Claim 1, comprising a step of configuring the prototype with a list of the logical modules and the routing of the signals.

5. Method according to Claim 1, comprising a step of analysing the criticality of the signals and a step of multiplexing the signals, the most critical signals being multiplexed with the lowest multiplexing ratios.

6. Prototyping system for implementing a design comprising a hierarchy of modules, comprising:
a board comprising physical tracks; and
a plurality of programmable chips interconnected by the conductive tracks, the programmable chips being configured by means of a method comprising: partitioning the hierarchy of modules into regions each comprising at least one programmable chip, by minimizing the inter-region communications in a manner correlated with the available physical connections between each pair of programmable chips, and the number of traversal(s) of programmable chips of a critical combinatorial path; and
establishing a routing of the signals between said programmable chips by using the available physical resources, wherein establishing the routing comprises routing the physical tracks of the board and the cables between programmable chips,
wherein modifications are applied in an iterative and automated manner to the partitioning before establishing a new routing and before estimating the operating frequency of the prototype formed by the programmable chips of said regions by means of a temporal analysis, until a target frequency is reached, the system furthermore comprising, prior to the partitioning, creating a new hierarchy of logic modules on the basis of the hierarchy of the logic modules of the logic design, by flattening the modules that cannot be preserved, according to design constraints, while implementing the logic design, and wherein the partitioning is applied to this new hierarchy.

7. System according to Claim 6, wherein establishing the routing of the signals comprises multiplexing the signals on the physical tracks of the board.

8. System according to Claim 7, wherein a multiplexing ratio is reduced by passing through other programmable chips in order to reach a final destination.

9. Computer program of the compiler type implementing a design comprising a hierarchy of modules on a prototyping system comprising a board comprising physical tracks and a plurality of programmable chips interconnected by the conductive tracks, the program being arranged to:
partition the hierarchy of modules into regions each comprising at least one programmable chip, by minimizing the inter-region communications in a manner correlated with the available physical connections between each pair of programmable chips, and the number of traversal(s) of programmable chips of a critical combinatorial path; and
establish a routing of the signals between said programmable chips by using the available physical resources, wherein establishing the routing comprises routing the physical tracks of the board and the cables between programmable chips,
wherein modifications are applied in an iterative and automated manner to the partitioning before establishing a new routing and before estimating the operating frequency of the prototype formed by the programmable chips of said regions by means of a temporal analysis, until a target frequency is reached, the program being furthermore arranged to, prior to the partitioning, create a new hierarchy of logic modules on the basis of the hierarchy of the logic modules of the logic design, by flattening the modules that cannot be preserved, according to design constraints, while implementing the logic design, and wherein the partitioning is applied to this new hierarchy.

10. Computer program according to Claim 9, wherein establishing the routing of the signals comprises multiplexing the signals on the physical tracks of the board.

11. Computer program according to Claim 9, wherein a multiplexing ratio is reduced by passing through other programmable chips in order to reach a final destination.
